# EUROPEAN PATENT APPLICATION

(11) **EP 1 482 316 A2**
(43) Date of publication of application: **01.12.2004**
(21) Application number: 04253179.8
(22) Date of filing: 28.05.2004
(51) Int. Cl.: G01R 19/10, G01R 15/14

(54) **Current measurement in electrical machines**

(30) Priority: 29.05.2003 GB 0312342
(71) Applicant: SWITCHED RELUCTANCE DRIVES LIMITED, Harrogate, North Yorkshire HG3 1PR (GB)
(72) Inventor: McClelland, Michael Leo, Calverley LS28 5PR (GB); Tankard, Michael Paul, Harrogate HG2 0EE (GB)
(74) Representative: Hale, Peter

(57) **Abstract**

An electrical machine has phase windings composed of coils connected in parallel. A current transducer is arranged to measure the current in only one of the coils and the total phase current is determined by scaling the output of the transducer according to the number of parallel branches in the phase winding.

## Description

The present invention generally relates to measurement of current. More particularly, the present invention relates to measurement of current in the phase winding of an electrical machine.

In installations involving electrical machines, there is generally the need to know the current in the machine, either for the purpose of control of the machine or for the purpose of protection of the machine or the supply in the event of a fault.

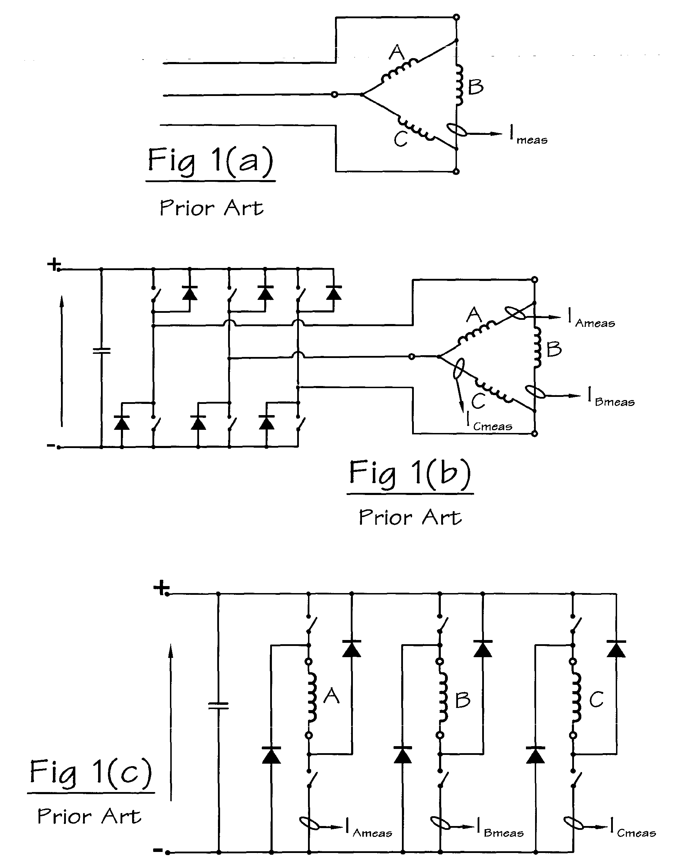

Figure 1(a) shows a known arrangement for measuring the phase current in a three-phase delta-connected machine. This is satisfactory if it can be assumed that the supply voltages are balanced and that the phases of the machines are identical. One current transducer can then be used to provide both the phase current and, by scaling, the supply current.

Figure 1(b) shows a known arrangement of current measurement in an inverter-fed system, where three current transducer(s) are used to allow the currents in the phase legs of the inverter to be monitored. Three transducers are generally used, since the voltages on the supply lines to the machine can no longer be assumed to be balanced. By suitable summing, and knowledge of the switch states in the inverter, the switch currents may be deduced.

Some electrical machines have phase windings which are independent of each other, so switch and phase winding currents can be measured with the same current transducer, as shown in Figure 1(c) for a switched reluctance machine. In this case, the phase winding current is identical to the switch current when the switches in a phase leg are closed.

In many cases, the current transducer signal must be isolated from the potential of the winding for safety reasons, so that galvanic isolation is achieved between the control circuit and the power circuit. This requires some form of isolating transducer. In an alternating current circuit for example, a current transformer could be used. However, in circuits where the currents have an offset about zero, current transformers are unsuitable and some form of flux-nulling device is normally employed. For example, transducers in the LA range made by LEM SA of Switzerland are commonly used. Such devices, however, are relatively expensive and in general the cost is in proportion to the maximum current rating of the device.

Several known methods of reducing the transducer cost are known. For example, US Patent No 4182982 (Wolf) divides a busbar into unequal branches and measures the current flowing in the smaller branch. However, the division of the current in the branches is not necessarily the same as the ratios of the cross sectional areas of the branches, since the reflected impedance of the transducer may be very significant compared to the self-impedance of the branch. Furthermore, the impedances will be frequency-dependent. Thus, although the system can be compensated for operation at a single frequency, this compensation is not effective over a frequency range. A similar system is disclosed in US Patent No 6528960 (Roden) which uses a current transducer coupled to one of a number of parallel-connected conductors. All such systems suffer from increasing error as the frequency of operation varies.

There is a need for a scheme which reduces the cost of current measurement while maintaining acceptable accuracy.

The present invention generally relates to a current measuring apparatus for indicating the current in a phase winding of an electrical machine, the winding having n coils connected in parallel, the apparatus comprising a single current transducer arranged in relation to one of the coils, to produce an output indicative of the current in that coil, and scaler means connected with the output of the transducer to produce a scaled output indicative of the total current in the phase winding.

Conveniently, the scaler means are operable to multiply the output of the transducer by n, thereby providing a direct correlation between the scaled output and the winding current.

It is possible to use embodiments of the invention to derate the current capacity of a current transducer to keep the device cost down.

The invention also extends to an equivalent method of measuring current.

Other aspects and advantages of the invention will become apparent upon reading the following detailed description of exemplary embodiments of the invention and upon reference to the accompanying drawings, in which:
Figure 1 shows known configurations of current transducers for different types of electrical machine;
Figure 2 shows a known transducer arrangement for an electrical machine; and
Figure 3 shows a transducer arrangement according to one embodiment of the invention.

Phase windings of electrical machines are generally made up of at least two multiturn coils. Usually, a flux pattern corresponding to one magnetic polarity is produced by one coil or group of coils suitably connected. Another coil, or another group of coils, is arranged at a suitable distance from the first, to produce a flux pattern of the opposite polarity. If a phase winding is required to produce a 2-pole pattern, then these two groups of coils can simply be connected in series or parallel, depending on the supply voltage and the flux required. If the coils are in series, each coil carries the phase current, whereas if the coils are in parallel, each coil carries a fraction of the phase current.

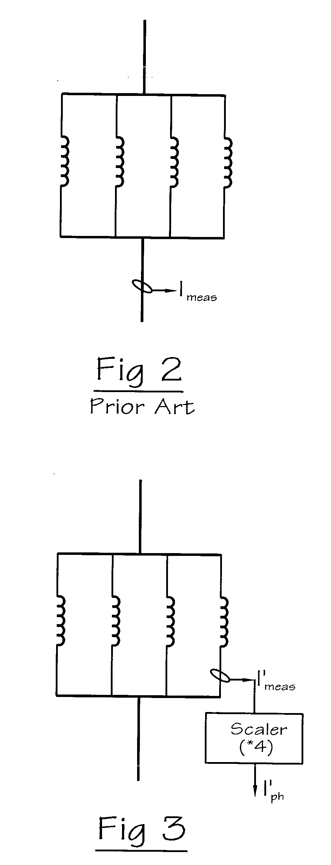

Figure 2 shows a schematic diagram of the winding of an electrical machine which has four coils per phase, with all four coils in parallel across the supply. The usual method of monitoring the phase current would be to position a current transducer as shown, so that the total current of all the coils is measured.

Figure 3 shows the same coils as in Figure 2, but now with the current measuring apparatus according to the invention. In this apparatus, a transducer is arranged to be exposed to the current I'ₘₑₐₛ in only one leg of the parallel arrangement of phase coils. Thus, the transducer measures only one quarter of the total phase current Iₚₕ. Provided that the current transducer does not present a significant reflected impedance into the circuit, the main power circuit is unchanged. The total current I'ₚₕ in the phase winding is now obtained by scaling the coil current by multiplying it by four using the scaler shown. This yields a measurement of the current phase winding by a transducer rated at only one quarter of the phase current. For n phase legs (four in this embodiment) the scaling is n.

It will be realised that this scheme has major advantages over the prior art. Firstly, it can use either isolated or non-isolated current transducers, according to the demands of the control system. Secondly, it is not affected by variations of frequency, since the inductance of the coils of the machine will swamp the reflected impedance of the transducer, so that the currents in the parallel branches will not be affected by the presence of the transducer. Typically, the inductance of the coils could be two orders of magnitude greater than the reflected impedance of the transducer. Thirdly, as the machine gets larger, more and more coils are typically arranged in parallel, so that one coil carries a smaller fraction of the total current, and the relative cost of the current transducer arrangement falls.

The skilled person will appreciate that variation of the disclosed arrangements are possible without departing from the invention. Accordingly, the above description of several embodiments is made by way of example and not for the purposes of limitation. It will be clear to the skilled person that minor modifications can be made to the arrangements without significant changes to the operation described above. The present invention is intended to be limited only by the scope of the following claims.

## Claims

1. A current measuring apparatus for indicating the current in a phase winding of an electrical machine, the winding having n coils connected in parallel, the apparatus comprising a single current transducer arranged in relation to one of the coils, to produce an output indicative of the current in that coil, and scaler means connected with the output of the transducer to produce a scaled output to give an indication of the total current in the phase winding.

2. Apparatus as claimed in claim 1 in which the scaler means are operable to multiply the output of the transducer by n.

3. A method of measuring current in a phase winding of an electrical machine, the winding having n coils connected in parallel, the method comprising:
arranging a single current transducer in a transducing relationship to one of the coils, thereby producing an output indicative of the current in that coil; and
scaling the output of the transducer to produce a scaled output indicative of the total current in the phase winding.

4. A method as claimed in claim 3 including scaling the transducer output by multiplying it by n.
